# EUROPEAN PATENT APPLICATION

(11) **EP 0 726 699 A1**
(43) Date of publication of application: **14.08.1996**
(21) Application number: 96300892.5
(22) Date of filing: 09.02.1996
(51) Int. Cl.: H05K 7/14

(54) **Modular electronic apparatus**

(30) Priority: 09.02.1995 JP 21428/95
(71) Applicant: NEC CORPORATION, Tokyo (JP)
(72) Inventor: Tamura, Tetsuya, Minato-ku, Tokyo (JP); Fujimoto, Jun, Minato-ku, Tokyo (JP); Maemura, Atsumi, Minato-ku, Tokyo (JP); Terauchi, Yukio, Minato-ku, Tokyo (JP); Tarasawa, Tomoya, Minato-ku, Tokyo (JP)
(74) Representative: Moir, Michael Christopher

(57) **Abstract**

A small-size electronic apparatus includes a plurality of units (11,12,13,14;27,28,29;43,44,45) each having a circuit board (63,71) and an independent housing (21,22,23; 37,38,39;53,54;66,67) accommodating various functional components on a function to function basis. Desired ones of the units can be interconnected by a connector or connectors which may be in the form of a cable (25,41) having a connector elements (24,40) at its two ends with which interface portions of the units are interconnected, or a connector pair having a male connector element and a female connector element (56,57;72,73) which permit direct interconnection for the units to be layered one on top of another. The connectors permits the removal or assembling of the units without requiring any tools, and the provision of additional units with no limitation being imposed on the number of units.

## Description

### BACKGROUND OF THE INVENTION

### (1) Field of the Invention

The present invention relates to modular electronic apparatus, and more particularly to a small-size electronic apparatus in which a plurality of circuit boards each having circuit components thereon, and various functional devices such as a floppy disk drive and a hard disk drive are respectively accommodated in metal or synthetic resin housings, and which is operated using a household power supply.

### (2) Description of the Related Art

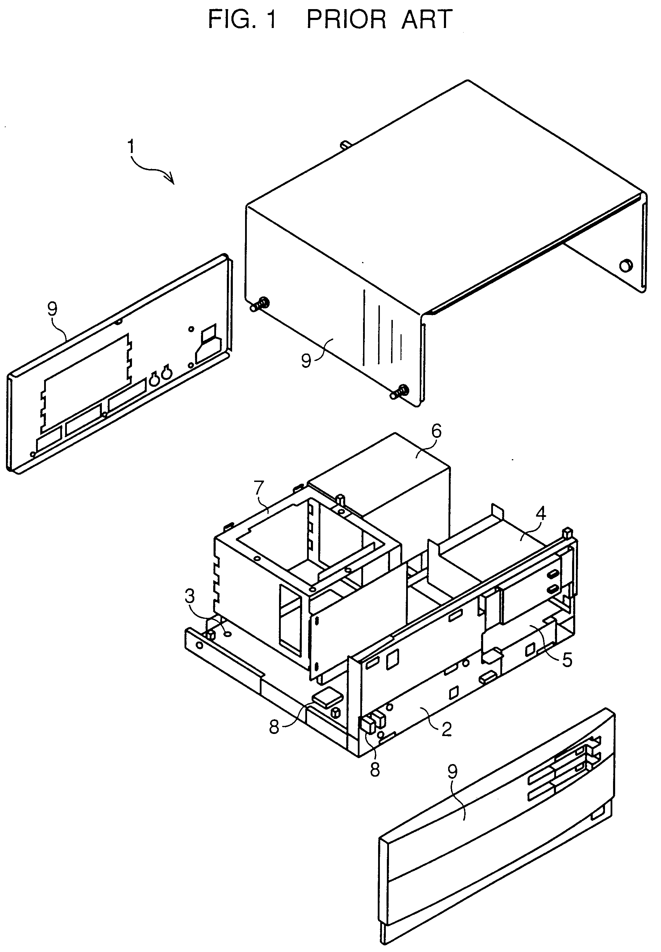

A prior art small-size electronic apparatus of the kind to which the present invention relates is first explained to assist the understanding of the present invention. An example thereof may be an input-output apparatus such as a personal computer. As shown in Fig. 1, the illustrated personal computer has a plate-like base frame 2 on which a plurality of circuit boards 3 with circuit components mounted thereon, a floppy disk drive 4, a hard disk drive 5, a power supply unit 6, an expansion cage unit 7 for inserting expansion circuit boards therein and various other functional units 8 are mounted. The base frame 2 with the component units mounted thereon is housed in a metal or synthetic resin housing 9.

In the above personal computer, all the circuit boards and functional units are connected to the frame 2 either directly or indirectly via other components. The connection is made by various mechanical coupling methods, such as one using screws, bolts, nuts, etc. of different shapes, dimensions and materials, and also those of snap fitting and bonding. The electrical connection is made by using connectors of different shapes between components to be coupled together in accordance with different purposes.

Recent personal computers may sometimes be required to adapt themselves to application software or apparatus used by the operator. Such adaptation requires operations of providing additional circuit components in circuit boards or on the expansion cage, providing additional drives of various recording media or replacing circuit components with new ones for version-up. To meet these requirements, there have been developed apparatuses in which screws connecting the base frame to the housing are special screw such as coin screws which do not require any tools for removal to permit ready removal of the housing, or in which a unit for the expansion cage is provided to permit provision of expansion circuit boards without removal of the housing but by merely removing a lid on an insertion slot. Japanese Patent Application Kokai Publication No. Hei 3-30007 shows a personal computer, which has a structure of permitting selective accommodation and connection of pack units such as optional modules. Japanese Patent Application Kokai Publication No. Hei 6-110579 shows a small-size electronic apparatus, which has an expansion space in which a plurality of circuit boards can be stacked one above another for mounting expansion circuit components on the stacked circuit boards, thus permitting additional provision or replacement of circuit components without the need of removing any circuit board unit from the housing or disassembling any circuit board unit.

In the prior art personal computer, as shown, all circuit boards, circuit components, drives, etc. are provided on and connected to one base frame and housed in one housing. Therefore, the replacement of any circuit board, circuit component or drive that is out of order or the disassembling of an apparatus to be discarded, always requires removal of the housing and separation of parts of different coupling systems. This requires considerable time and labor. Sometimes, the circuit boards or circuit components, or even the apparatus frames, which are not out of order are nevertheless replaced or discarded, thus curtailing the utility life of the personal computer.

Also, since the prior art personal computers of the type explained above are mostly placed on a desk when used, it is desired that the volume occupied by the housing be minimized. The prior art personal computer is housed in a single housing, and for permitting additional provision of circuit boards or circuit components or selective removal of circuit boards or circuit components for version-up, an expansion space has to be provided in the housing. The provision of such expansion space in the housing, however, is based on the estimate of additional provision, and therefore makes the personal computer itself to be unnecessarily bulky.

### SUMMARY OF THE INVENTION

An aim of the invention, therefore, is to overcome the problems existing in the prior art, and to provide a small-size electronic apparatus which permits 1) separation and replacement of circuit boards, circuit components, functional units such as drive units, etc. without removing the housing by using tools or disassembling the circuit boards or circuit components, 2) ready mounting of expansion circuit boards or circuit components or version-up circuit boards, when necessary, without any preliminary provision of an expansion space, thus extending the life of the apparatus, 3) ready separation and disassembly of unit to be discarded, and 4) realization of size reduction of the apparatus.

According to a first aspect of the invention there is provided a modular electronic apparatus as in Claim 1.

According to a second aspect of the invention there is provided an electronic module as in Claim 2.

According to a third aspect of the invention, there is provided a small-size electronic apparatus comprising:
a plurality of units each having a circuit board and an independent housing accommodating therein various functional components on a function to function basis; and
at least one connecting means provided in each of the plurality of units, the connecting means being connected to desired one of the plurality of units.

According to a fourth aspect of the invention, there is provided a small-size electronic apparatus having a combination of a plurality of units each comprising a circuit board and various functional components housed independently in the units on a function to function basis, each of the units further comprising:
a unit frame in which the circuit board and the functional components are mounted, and which has a connector for electrically being connected to a circuit board and functional components of other units in a direction of connection to the other units;
a front panel which has a first and a second fit coupling means, the front panel being connected to and removed from the unit frame by the first fit coupling means; and
a housing which receives the unit frame, and which has a guide rail means for interconnecting the housing with the unit frame and a unit connection surface having a locking means for interconnecting and locking the units together, such that, by causing the housing to slide along the guide rail means toward the front panel, the housing is secured to the unit frame and the front panel by the second fit coupling means, and also housings of the plurality of units are interconnected and locked.

Accordingly, each unit may have an independent housing which accommodates a circuit board or a functional component. Thus, the operations of replacing circuit boards, circuit components and drive units for version-up or in the case of break down and also disassembling an apparatus to be discarded may be done by merely removing the connector of the unit to be replaced or disassembled. In addition, a new unit can be additionally provided in a simple operation of merely coupling it to a vacant connector. No limitation is thus imposed on the number units to be additionally provided, thus permitting life extension of the apparatus.

Accordingly, it may not be necessary to provide in the housing of a unit an expansion space for additionally providing circuit boards and circuit components or selectively removing those for version-up. Each unit thus can be produced with a minimum necessary size, and size reduction of the apparatus can be realized.

Where housings are produced such that they have the same dimensions, it is possible to re-use housings which have become unnecessary.

With the provision of a connector which is a connector pair comprising a male and a female connector on connection surfaces of each unit, units can be connected to each other by directly connecting their connectors without needing any cable or cord, thus permitting corresponding space saving and realizing further space saving of the apparatus.

Moreover, the individual units can be assembled such that they are stacked to reduce the installation space occupied by the small-size electronic apparatus according to the invention and thus obtain space saving of the apparatus.

With the structure of the fourth aspect of the invention, in addition to the above effects, the front panel and the housing can be readily removed from the unit frame. It is thus possible to disassemble a unit which has become unnecessary or a unit which requires repair into the circuit board, components, front panel and housing in a simple operation using no tools. Improved disassembling property thus can be realized.

### BRIEF DESCRIPTION OF THE DRAWINGS

The above and other objects, features and advantages of the present invention will be apparent from the following description of preferred embodiments of the invention explained with reference to the accompanying drawings, in which:
Fig. 1 is an exploded perspective view showing a prior art small electronic apparatus;
Fig. 2 is a block diagram showing an arrangement of a first embodiment according to the invention applied to a personal computer;
Figs. 3A and 3B are perspective views showing a CPU in the first embodiment, Fig. 3A being taken from the front side and Fig. 3B being taken from the rear side;
Figs. 4A and 4B are perspective views showing the personal computer in the first embodiment, Fig. 4A being taken from the front side and Fig. 4B being taken from the rear side;
Fig. 5 is a block diagram showing an adaptation of the first embodiment personal computer with additional provision of a unit 18;
Fig. 6 is a block diagram showing a personal computer of a second embodiment according to the invention;
Figs. 7A and 7B are perspective views showing a CPU in the second embodiment, Fig. 7A being taken from the front side and Fig. 7B being taken from the rear side;
Figs. 8A and 8B are perspective views showing the second embodiment personal computer, Fig. 8A being taken from the front side and Fig. 8B being taken from the rear side;
Fig. 9 is a block diagram showing an adaptation of the second embodiment personal computer with additional provision of a unit 33;
Fig. 10 is a block diagram showing an adaptation of the second embodiment personal computer obtained by interchanging the connection sequence of units;
Fig. 11 is a block diagram showing an adaptation of the second embodiment personal computer obtained by replacing and discarding a unit 29;
Fig. 12 is a block diagram showing a personal computer as a third embodiment and a fourth embodiment;
Figs. 13A and 13B are perspective views showing a CPU in the third embodiment, Fig. 13A being taken from the front side and Fig. 13B being taken from the rear side;
Figs. 14A and 14A are perspective views showing the third embodiment personal computer, Fig. 14A being taken from the front side and Fig. 14B being taken from the rear side;
Fig. 15 is a block diagram showing an adaptation of the third embodiment personal computer with additional provision of a unit 61;
Fig. 16 is a block diagram showing an adaptation of the third embodiment personal computer obtained by interchanging the connection sequence of units;
Fig. 17 is a block diagram showing an adaptation of the third embodiment personal computer obtained by replacing and discarding a unit 46;
Fig. 18 is a perspective view showing a CPU in a fourth embodiment;
Figs. 19A and 19B are sectional views showing the CPU taken along line 19A-19A in Fig. 18, Fig. 19A showing a state before fitting and Fig. 19B showing a state after fitting;
Fig. 20 is a sectional view showing the CPU taken along line 20-20 in Fig. 18;
Fig. 21 is a sectional view showing the CPU taken along line 21-21 in Fig. 18; and
Fig. 22 is a perspective view showing the personal computer of the fourth embodiment according to the invention.

### PREFERRED EMBODIMENTS OF THE INVENTION

Now, preferred embodiments of the invention are explained with reference to the drawings by way of example only.

### EMBODIMENT 1

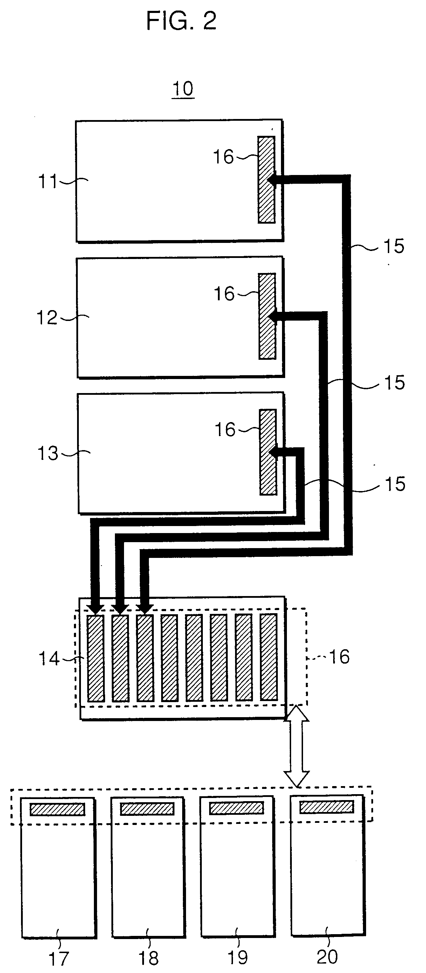

Fig. 2 is a block diagram showing an arrangement of a first embodiment of the invention applied to a desk top type personal computer 10, with only essential functional units being shown. Specifically, the personal computer 10 comprises a power supply unit 11, a CPU (Central Processing Unit) 12, a hard disk unit 13, a connector unit 14 and a common system bus 15. The individual units have common interfaces 16 for their connection to the common system bus 15. The connector unit 14 has eight interfaces, while each of the other units has one interface 16. Connectors of the same type and same shape can be connected to the interfaces 16. Via the common system bus 15, there can be connected a TV tuner unit 17, a PCMCIA (Personal Computer Memory Card International Association Standard) card slot unit 18, a CD-ROM unit 19 and various expansion functional units 20, such as a floppy disk unit, an expansion RAM unit, a sound board unit, an Ethernet board unit, a SCSI (Small Computer System Interface) board unit, an accelerator board unit, etc., as well as the power supply unit 11, the CPU unit 12, the hard disk unit 13 and the connector unit 14. The individual units thus are capable of being bi-directionally accessed by one another via the connector unit 14 for power, control signals from the CPU to other units, and response signals and data signals from the other units to the CPU. Because of the use of the common bus system, a unit can be connected to a connector in a desired place for connection to the connector unit 14. Moreover, with the connection of the connector unit 14, no limit is imposed on the number of units which are to be connected, that is, it is possible to connected any number of additional units.

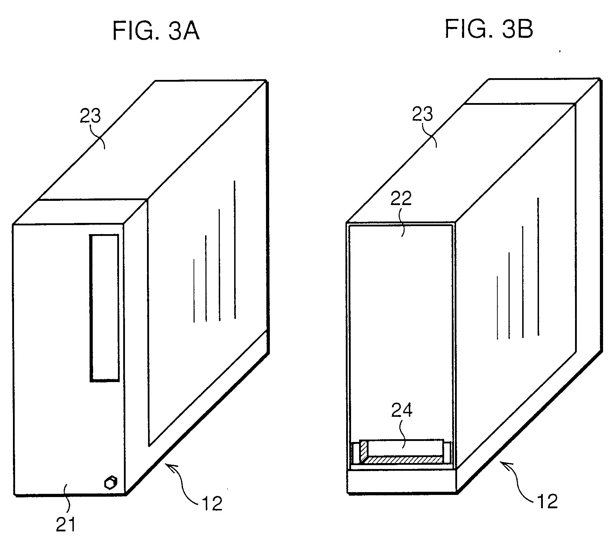

Figs. 3A and 3B show the structure of the CPU unit 12. This unit as well as all the other units is enclosed in a recycling ABS resin housing with a width of 4 cm, a depth of 30 cm and a height of 20 cm. From the consideration of the recycling and discarding, it is constructed with a small number of parts, i.e., three parts, specifically a main panel 21, a rear panel 22 and a roof panel 23. These parts are made of the same material which may be a metal material, such as an aluminum or magnesium alloy. The coupling of the respective housing parts and also the coupling of the base and components to the housing are all made by snap fitting (i.e., securing together without use of any screws but with engagement of pawl projections in holes) so that disassembling can be made without requiring any tools. The other units also have the same structure. The interface 16 is provided on the rear panel 22, and it has one connector 24.

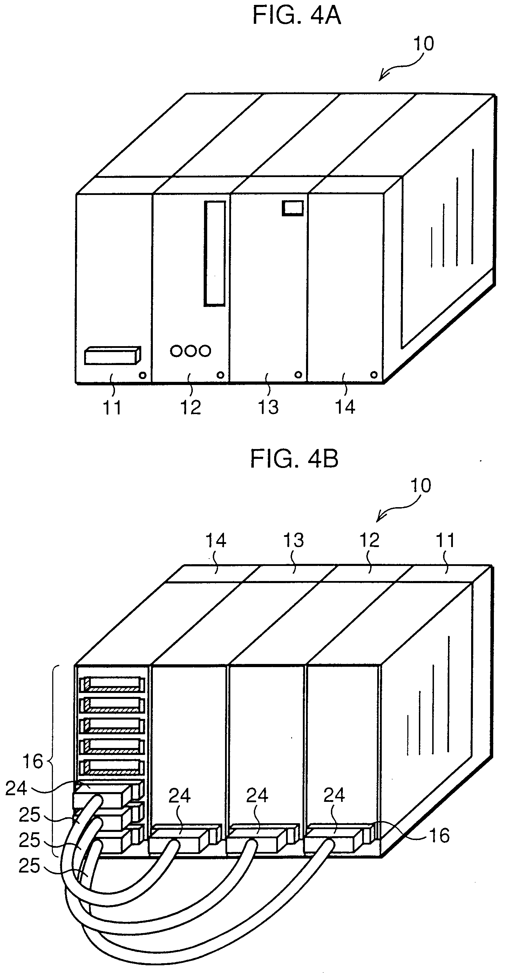

Figs. 4A and 4B show the structure of the desk top type personal computer 10 comprising essential functional units only, i.e., the power supply unit 11, the CPU unit 12, the hard disk unit 13 and the connector unit 14.

In the power supply unit 11, the rear face has the interface 16, and a power unit is assembled, which receives household power (AC 100 volts) as input power and supplies output power up to eight units via the common system bus 15 (cable 25). In the connector unit 14, the rear face has eight interfaces 16, and the front face has a plurality of connectors (not shown) respectively for a keyboard, a pointing device and a display device. The CPU unit 12 uses a CPU board carrying thereon a CPU chip ("DX-4", 100 MHz) manufactured by Intel Inc., in U.S.A., with which the "MS-DOS" produced by Microsoft Inc., in U.S.A., is capable of running as an operating system. Its memory includes an 8.0 MB RAM. The hard disk unit 13 includes a 540 MB hard disk. Interconnection between the units is effected by a cable 25, each end of which has a connector 24 capable being connected to the interface 16. Provision of additional units or removal of units thus can be achieved by a simple operation of connecting or removing of the cables 25.

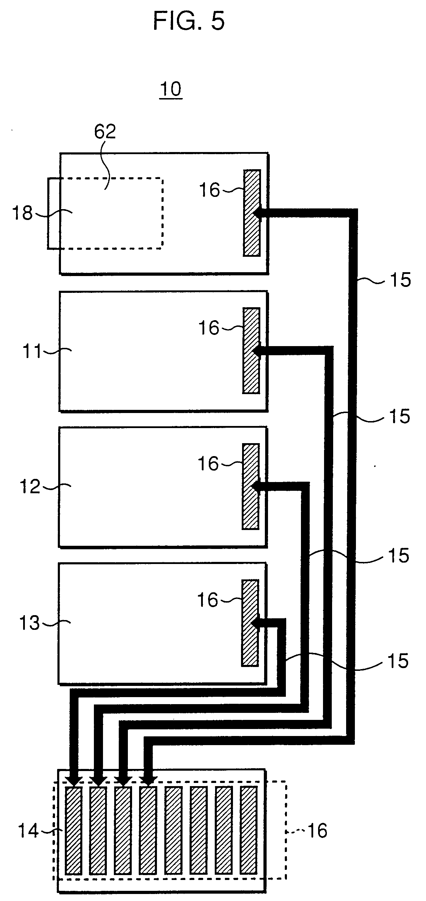

Fig. 5 is a block diagram showing a case where a PCMCIA card slot unit 18 is additionally provided. The PCMCIA card slot unit 18 has a card slot, in which two Type II (memory card standard) cards can be inserted at a time or a single Type III (memory card standard) card can be inserted. The additional provision of the unit 18 can be made by merely connecting one end of the cable 25 to a vacant connector in the connector unit 14 without any unit connected thereto and connecting the other end of the connector to the unit 18. The operation of the additional provision thus can be finished without needing any special tools and without removing the housing. Besides, it is not necessary to preliminarily provide the personal computer with any additional provision space for selectively removably mounting additional provision or version-up circuit board or circuit parts. When discarding unnecessary unit or replacing with a version-up unit, the unnecessary unit can be easily removed by the converse operation to the additional provision operation.

The PCMCIA card 62 that may be inserted into the card slot includes an Ethernet card, a SCSI card, a GPIB (General Purpose Interface Bus) card, a FAX modem card, a hard disk card, a flash memory card, a software card, etc. Mere insertion of an intended card or intended cards into the slot effects circuit connection, thus permitting further provision of expansion units.

### EMBODIMENT 2

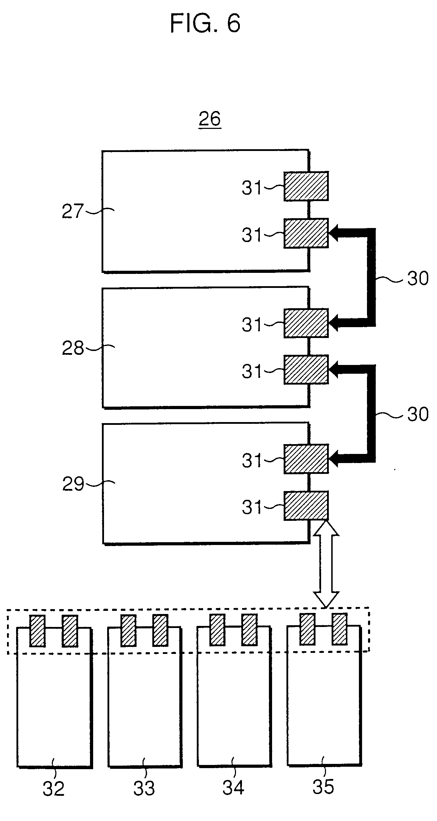

Fig. 6 is a block diagram showing Embodiment 2 of the invention applied to a desk top type personal computer 26 comprising essential functional units only. The personal computer 26 comprises a power supply unit 27, a CPU unit 28, a hard disk unit 29, and a common system bus 30. The individual units have common interfaces 31 for their connection to the common system bus 30. The individual units each have two interfaces 31, and connectors of the same type and same shape can be connected to the interfaces. Via the common system bus 30, there can be connected, in addition to the above power supply unit 27, CPU unit 28 and hard disk unit 29, a TV tuner unit 32, a PCMCIA card slot unit 33, a CD-ROM unit 34 and various expansion functional units 35, such as a floppy disk unit, an expansion RAM unit, a sound board unit, an Ethernet board unit, a SCSI board unit, an accelerator board unit. The individual units are thus capable of being bi-directionally accessed by one another for power, control signal from the CPU to other units and response signal and data signal from other units to the CPU. Because of the use of the common system bus, a desired unit can be serially connected in a desired place. That is, a new unit can be connected to a vacant interface 31 available for connection. No limitation is thus imposed on the number of units which are to be connected, and it is possible to connect any number of additional units.

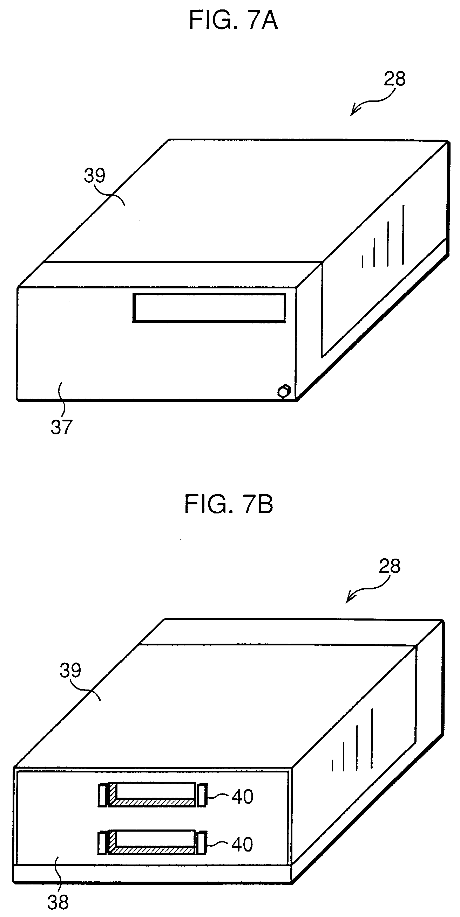

Figs. 7A and 7B show the structure of the CPU unit 28, Fig. 7A being a front view and Fig. 7B being a rear view. This unit as well as all the other units is enclosed in a recycling ABS resin housing (20 cm in width, 30 cm in depth and 4 cm in height). From the consideration of the recycling and discarding, the unit is constructed with a small number of parts, i.e., three parts, specifically a main panel 37, a rear panel 38 and a roof panel 39. These parts are made of the same material. The material may be a metal material, such as an aluminum or magnesium alloy. The assembling of the housing parts and also the mounting of the functional components to the housing are all made by snap fitting, so that disassembling can be made without needing any tools. The other units also have the same structure. Two connectors 40 are provided on the respective interfaces 31 on the rear panel 38.

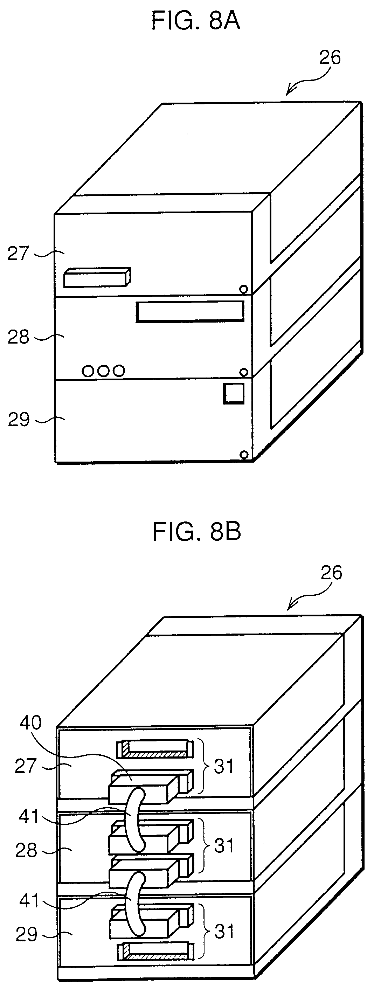

Figs. 8A and 8B show the structure of the desk top type personal computer 26 comprising essential functional units only, i.e., a power supply unit 27, a CPU unit 28 and a hard disk unit 29. In the power supply unit 27, the rear face has an interfaces 31, and a power unit is assembled, which receives household power (AC 100 volts) as input power and supplies output power up to eight units via the common system bus 30. The CPU unit 28 uses a CPU board carrying thereon a CPU ("DX-4, 100 MHz) manufactured by Intel Inc., in U.S.A., with which the "MS-DOS" produced by Microsoft Inc., in U.S.A., is capable of running as an operating system. Its front face has connectors for a keyboard, a pointing device, and a display. Its memory includes an 8.0 MB RAM. The hard disk unit 29 includes a 540 MB hard disk. Two units can be interconnected by a cable 41 each end of which has a connector 40 capable of being connected to an interface 31. Provision of additional units or removal of units thus can be achieved by a simple operation of connecting or removing of the cables 41.

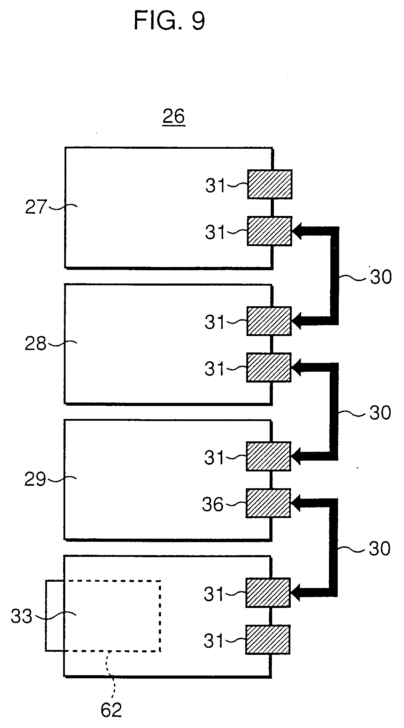

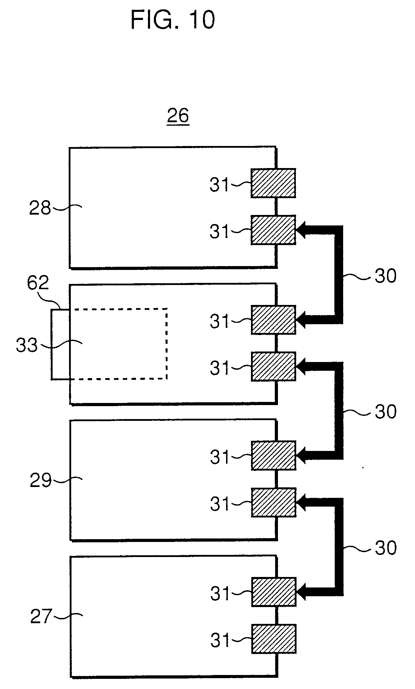

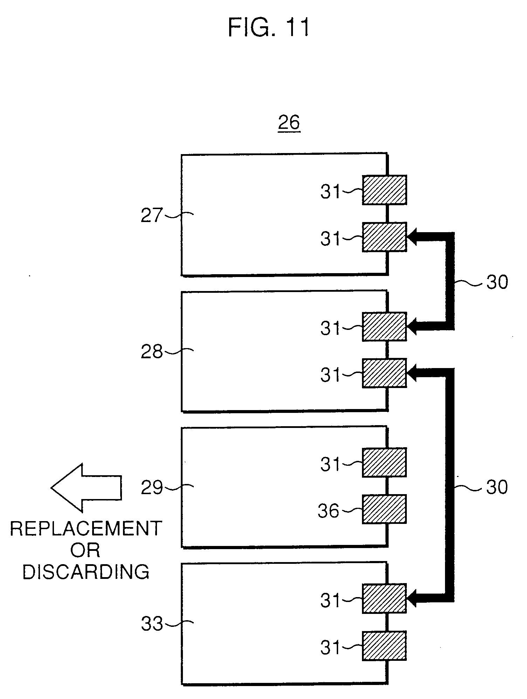

Fig. 9 is a block diagram showing a case where a PCMCIA card slot unit 33 is additionally provided. The PCMCIA card slot unit 33 has a card slot, in which two Type II cards can be inserted at a time or a single Type III card can be inserted. The additional provision of the unit 33 can be made by merely connecting an interface 31 of the unit 33 to a vacant interface 31 available in the hard disk unit 29 by using a cable 41 (common system bus 30). The operation of the additional connection can be thus finished without needing any special tools and without removing the housing. Besides, it is not necessary to preliminarily provide the personal computer with any additional provision space for selectively removably mounting additional provision or version-up circuit board or circuit parts. When discarding unnecessary unit or replacing with a version-up unit, the unnecessary unit can be easily removed by the converse operation to the additional provision operation. Furthermore, since the individual units are serially connected via the common system bus 30, it is possible to easily interchange the connection sequence of units as shown in the block diagram of Fig. 10 or made additional provision or replacement of a unit between non-terminated units as shown in the block diagram of Fig. 11 by merely changing the opposite side of the pertinent connection cable 41.

The PCMCIA card 62 that is inserted into the card slot may include an Ethernet card, a SCSI card, a GPIB card, a FAX modem card, a hard disk card, a flush memory card, a software card, etc. Mere insertion of an intended card or intended cards into the slot effects circuit connection, thus permitting further provision of additional units.

### EMBODIMENT 3

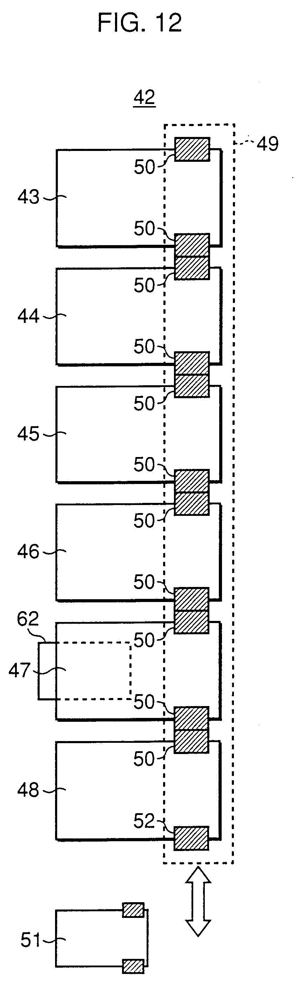

Fig. 12 is a block diagram showing a desk top type personal computer 42 comprising multi-media-support units. Specifically, the personal computer 42 comprises a power supply unit 43, a CPU unit 44, a hard disk unit 45, a TV tuner unit 46, a PCMCIA card slot unit 47, a CD-ROM unit 48, and a common system bus 49. The individual units have common interfaces 50 for their connection to the common system bus 49, that is, each unit has two common interfaces 50. Connectors of the same type can be connected to the interfaces 50. Via the common system bus 49, there can be connected the power supply unit 43, the CPU unit 44, the hard disk unit 45, the TV tuner 46, the PCMCIA card slot unit 47 and the CD-ROM unit 48, and also various expansion functional units 51, such as a floppy disk unit, an expansion RAM unit, a sound board unit, an Ethernet board unit, a SCSI board unit, an accelerator board unit. The individual units are thus capable of being bi-directionally accessed by one another for power, control signals from the CPU to other units, and response signals and data signals from the other units to the CPU. Because of the use of the common system bus system, a unit can be connected serially in a desired place. Moreover, a new unit (such as any of the expansion functional units 51) may be connected to a vacant interface 52 available in an end unit (terminal unit). No limitation is thus imposed on the number of units which are to be connected, and it is possible to connect any number of additional units.

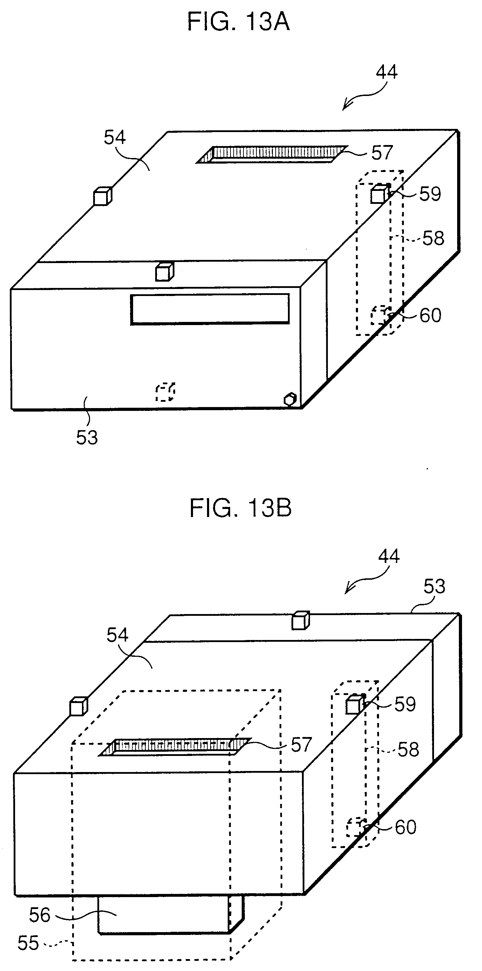

Figs. 13A and 13B show the structure of the CPU unit 44. This unit as well as all the other units is enclosed in a recycling ABS resin housing (a width of 20 cm, a depth of 30 cm and a height of 4 cm). From the consideration of the recycling and discarding, it is constructed with a small number of parts, i.e., two parts, specifically a main panel 53 and a body 54. These parts are made of the same material which may be a metal material, such as an aluminum or magnesium alloy. The assembling of the housing parts and also the coupling of the base and components to the housing are all made by snap fitting so that disassembling can be made without needing any tools. The other units also have the same structure.

The body 54 has a connector unit 55 for connecting interfaces 50 of two units. The connector unit 55 has two, i.e., male and female, connectors 56 and 57. The male and female connectors 56 and 57 are provided on the top and bottom, respectively, of the body 54 at corresponding positions. Unit securing means 58 for securing units together is provided on the top and bottom of the body 54. The unit securing means 58 has a protuberance 59 and a recess 60 provided on the top and in the bottom of the body 54, respectively. Two units up and down can be secured to each other by the friction between their protuberances 59 and recesses 60. It is possible to use other unit securing means as well, which have a small number of components and require no tools for the coupling and releasing, such as coupling hooks, coupling rings, coupling pins, snap fitting.

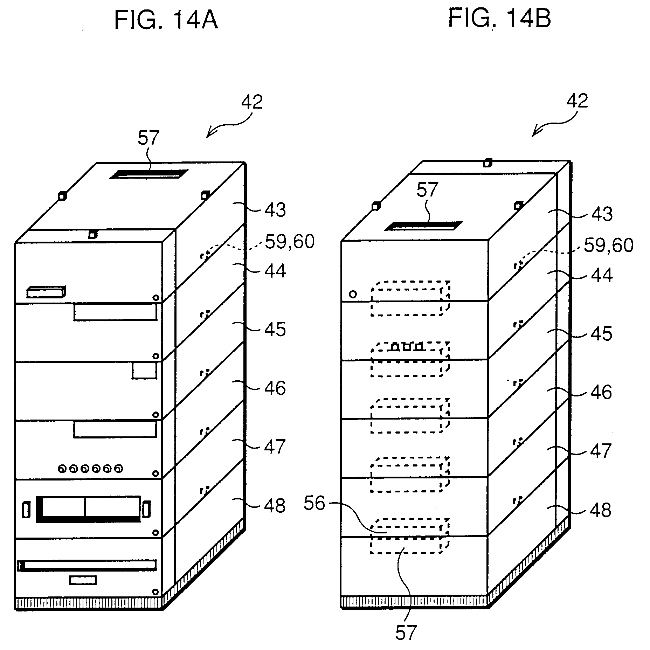

Figs. 14A and 14B show the configuration of the desk top type personal computer 42 comprising multi-media-support units. The personal computer 42 comprises the power supply unit 43, the CPU unit 44, the hard disk unit 45, the TV tuner unit 46, the PCMCIA card slot unit 47 and the CD-ROM unit 48. The power supply unit 43 has the interfaces 50 provided on its rear surface, and it includes a power unit which receives input power from a household power source (AC 100 volts) and can supply output power up to eight units via the common system bus 49. The CPU unit 44 uses a CPU board carrying thereon a CPU ("DX-4", 100 MHz) manufactured by Intel Inc., in U.S.A., with which the "MS-DOS" produced by Microsoft Inc., in U.S.A., is capable of running as an operating system. On the rear surface of the CPU 44, there are provided a plurality of connectors for a keyboard, a pointing device and a display device. As memory of the CPU unit 44, a 8.0 MB RAM is mounted. In the hard disk unit 45 a 540 MB hard disk is mounted. The CD-ROM unit 48 includes a CD-ROM drive of a quad-speed (average access time: 230 ms) which supports a photo CD (multi-session). The TV tuner unit 46 has a video board for displaying TV pictures in desired sizes on a personal computer monitor, a TV tuner (VHF: 1 to 12 ch./UHF: 13 to 62 ch.) conforming to the sound multiplexed system, two external video input terminals (RCA pins and S terminals), stereo sound input/output terminals, and antenna input terminals. The PCMCIA card slot unit 47 has a card slot, in which two Type II cards can be inserted at a time or a single Type III card can be inserted. The PCMCIA card 62 which is inserted into the card slot may include an Ethernet card, a SCSI card, a GPIB card, a FAX modem card, a hard disk card, a flush memory card, a software card, etc. Mere insertion of an intended card or intended cards into the slot effects circuit connection, thus permitting further provision of additional units.

Two units can be connected together by directly connecting the male connector 56 of an interface 50 of one of them to the female connector 57 of the other, and the female connector 57 of one of them to the male connector 56 of the other, and also fitting the protuberances 59 of one of them to the recesses 60 of the other. In this way, it is possible to combine a plurality of units in a stacked form with their housings secured to one another. The connection can be made in a simple operation without cumbersome connection of cables or cords or any space for cables or cords for the connection.

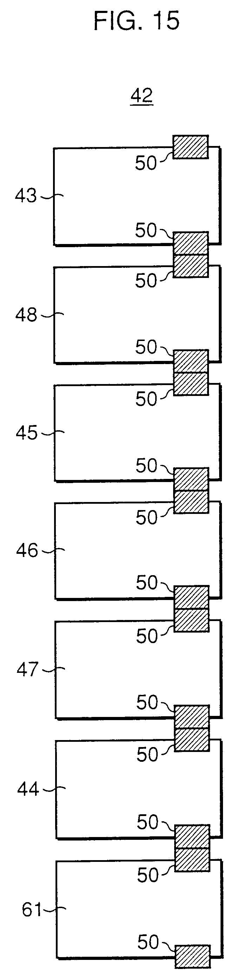

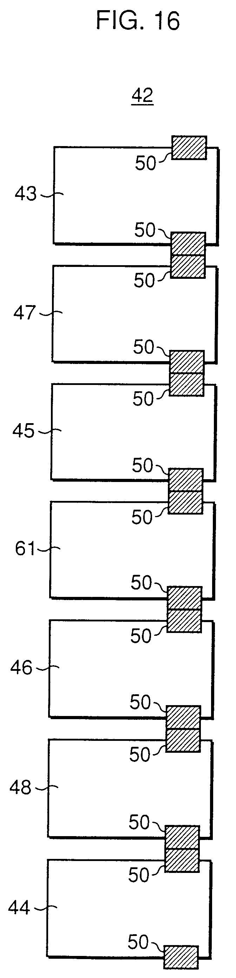

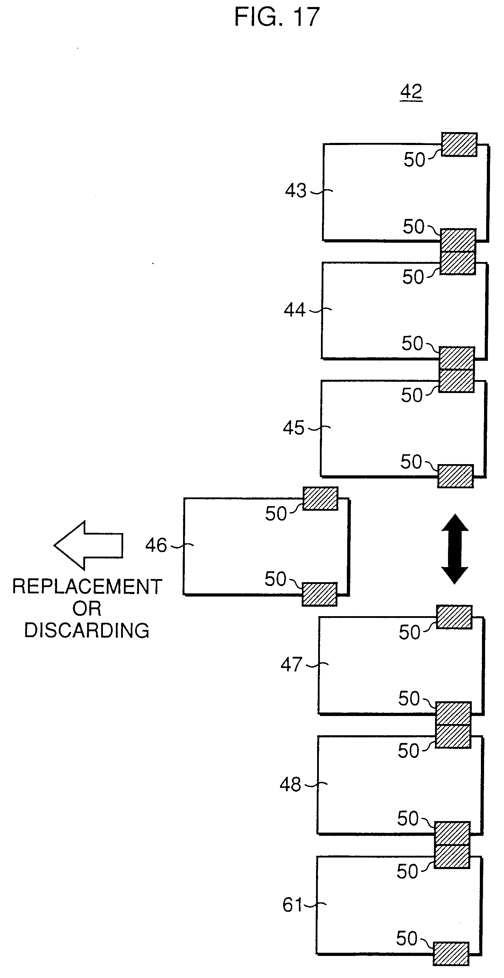

Fig. 15 is a block diagram showing a case where a floppy disk unit 61 is additionally provided. The floppy disk unit 61 includes a 3-mode (of about 640 KB, about 1 MB and 1.44 MB) 3.5-inch floppy disk drive. This drive may be replaced with a 5-inch floppy disk drive. The additional provision of the floppy disk unit 61 can be made by merely connecting the male connector 56 on the bottom of an interface 50 of the unit 61 to the female connector 57 on the top of a vacant interface 50 available in the CPU unit 44 at the end. The additional provision thus can be made without needing any special tools and also without removing the housing. Replacement can also be easily made by the converse operation. Moreover, interchange of the connection sequence of units or additional provision or replacement of units between non-terminal units can be easily achieved by merely changing the unit to which the connector unit 55 is connected. It is not necessary to preliminarily provide the personal computer body with an expansion space for additional provision of circuit boards or circuit components and selective removal of version-up circuit boards or circuit components. It is also possible to easily remove unnecessary units to be discarded or units to be replaced for version-up by the converse operation to the additional provision. Since each unit is serially connected via the common system bus 49, it is possible to achieve interchange of the connection sequence of the Fig. 15 units as shown in Fig. 16 or additionally provide or replace units between non-terminal units as shown in Fig. 17 by merely changing the unit to which the connector unit 55 is connected.

### EMBODIMENT 4

Embodiment 4 of the invention will now be described with reference to the drawings. This embodiment again comprises essential functional units only and is applicable to the personal computer shown in Fig. 6 or to the personal computer comprising the multi-media-support units as shown in Fig. 12. This embodiment will be described in connection with a personal computer comprising multi-media-support units shown in Figs. 12 and 22.

The units used in this embodiment are like those shown in Embodiment 3, and because of the use of common bus system it is possible to connect a desired unit serially in a desired place. Any unit can be connected to a vacant interface 52 available in a terminal unit. No limitation is thus imposed on the number of units to be additionally provided.

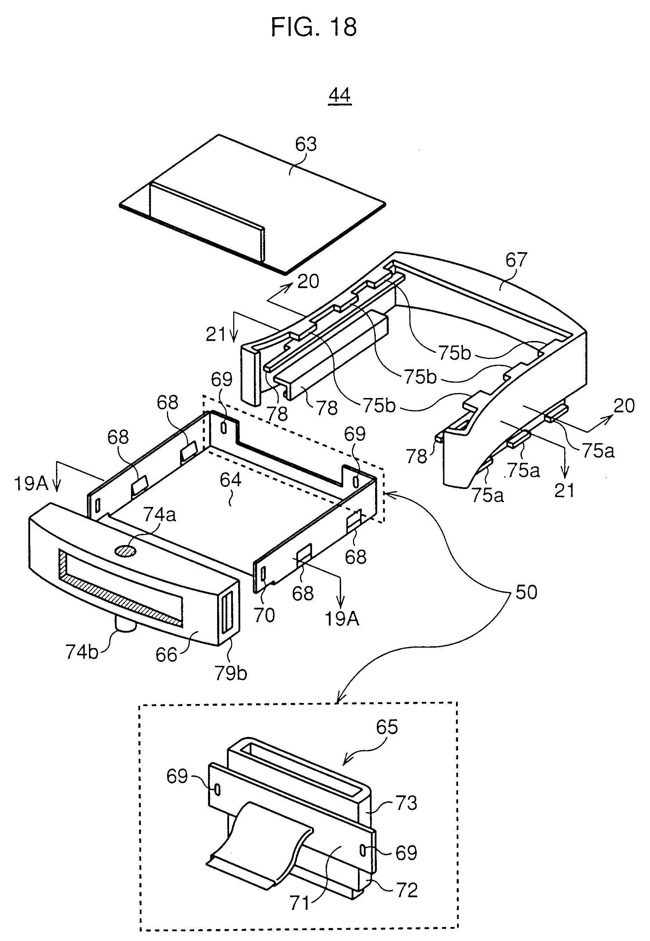

A feature of this embodiment resides in the structure of the units. Fig. 18 shows the structure of the CPU unit as an example of the unit structure. The CPU unit 44, as shown, comprises a CPU circuit board 63, a unit frame 64, a connector 65 of an interface 50 mounted in the unit frame 64, a front panel 66, and a housing 67. All the units of the embodiment have this basic structure.

The CPU circuit board 63 uses a CPU board carrying thereon a CPU chip ("DX-4", 100 MHz) manufactured by Intel Inc., in U.S.A., with which the "MS-DOS" developed by Microsoft Inc., in U.S.A., is capable of running as an operating system. It is provided on the unit frame 64. Where a plurality of CPU circuit boards are used, they are arranged one on top of another with respective spacings being provided therebetween. In the unit frame 64, a liquid crystal display panel for displaying the CPU operating state and the system control state is mounted.

The unit frame 64 is made from an aluminum plate, or it may be made of other materials, either metal materials such as an iron plate or a magnesium alloy plate or synthetic resin materials. The unit frame 64 has side walls which are provided with a plurality of threaded holes or snap fitting holes 68 for securing circuit boards or functional components assembled in the unit in conformity to specific dimensions. Its rear wall has two threaded holes 69 for mounting an interface part. Its side walls near end portions thereof have holes 70 for mounting the front panel.

The CPU circuit board 63 is set on the unit frame 64 and secured by using the snap fitting holes 68, and it can be removed without use of any tools. As an alternative, the CPU circuit board 63 and the unit frame 64 may be secured to each other with screws and bolts, or they may be molded as one-piece molding from a synthetic resin or the like.

The connector 65 of the interface 50 has an interface circuit board 71 to be connected to circuit boards and functional components and 120-pin male and female connectors 72 and 73 mounted on the interface circuit board 71. The interface circuit board 71 is electrically connected to the circuit boards and functional components either directly or via cables. Two, i.e., upper and lower, units are electrically inter-connected by the male and female connectors 72 and 73. The connector 65 is mounted on the rear surface of the unit frame 4 such that it is vertical to unit connection surface so that the direction of connection of the male connector 72 is toward the bottom of the unit and that the direction of connection of the female connector 73 is toward the top of the unit.

The front panel 66 and the housing 67 have the same outer dimensions in all the units and are made of a recycling ABS resin. Their fabrication in the same sizes permits their re-use when they become unnecessary. However, the individual units may not be fabricated to have the same outer dimensions as they may have different heights so long as they have an equal bottom surface area. In view of the recycling and discarding, the number of the components of the unit is made to be as small as possible. The front panel 66 and the housing 67 are made of the same material. The material may be metal materials such as an aluminum or magnesium alloy as well as resin materials.

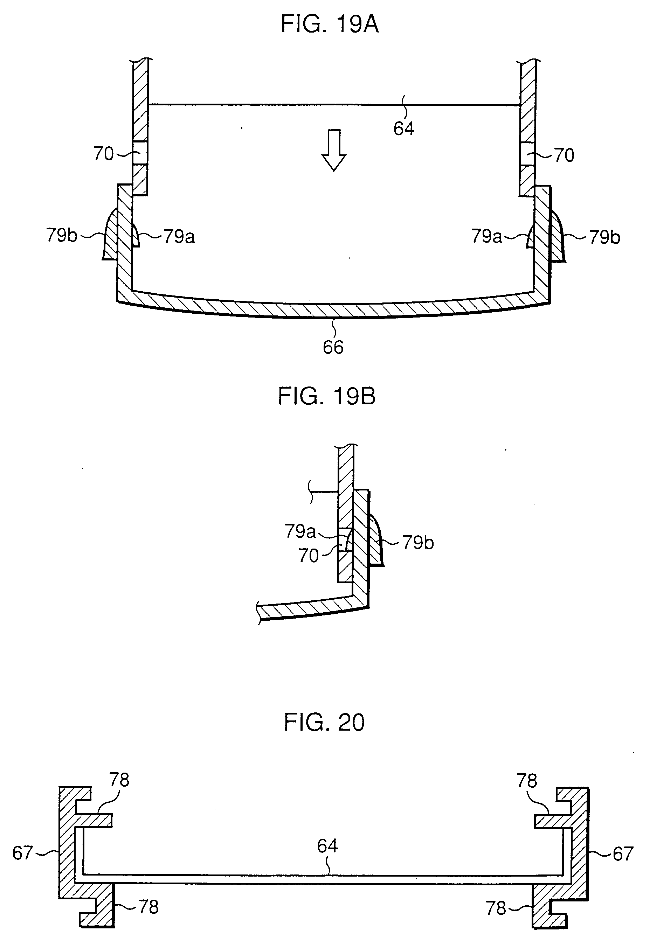

The front panel 66 has an opening, which is formed in correspondence to the position of the liquid crystal display panel mounted in the CPU circuit board. In order to prevent deviation of the unit from the coupling position with respect to a different unit, the front panel 66 is provided with positioning guides 74, i.e., a recess 74a formed in its top and a protuberance 74b formed on its bottom. The connection of the front panel 66 and the unit frame 64 to each other, is made such that they can be removed from each other without use of any tools. Specifically, as shown in Figs. 19A and 19B (which are sectional views taken along line 19A-19A in Fig. 18), the fitting is effected by using snap fit portions 79a provided on the inner surface of the front panel 66 in front panel mounting holes 70 provided on the unit frame 64 adjacent the front end thereof. Fig. 19A shows a state before the fitting, and Fig. 19B shows a state in which the snap fitting portions 79a of the front panel 68 are fitted in the holes 70 of the unit frame 64.

The connection of the front panel 66 to the housing 67, similarly as the connection to the unit frame 64, is made by using snap fit portions 79b provided on the outer surface of the front panel 66 such that the front end of the housing 67 is fitted.

The housing 67, as shown in Fig. 18, is a one-piece molding having only side walls and a rear wall to permit stacked coupling of other units to its top and bottom. A cover plate is mounted on a unit which is stacked as the uppermost unit in a stack. For securing and releasing the units stacked and coupled one over another, the housing 67 has an inter-unit coupling lock mechanism 75. The lock mechanism 75 has six lock pawls 75a provided on a lower portion of the side walls and six lock notches 75b formed in an upper portion of the side walls. The housing 67 and the frame unit 64 are connected to each other such that they can be removed without use of any tools. Specifically, as shown in Fig. 20 (which is a sectional view taken along line 20-20 in Fig. 18), the unit frame 64 is fitted in guide rails 78 provided on the inner surfaces of the housing 67. Sliding of the housing 67 back and forth relative to the unit frame 64 can be caused by releasing the snap fit portions 79b for connecting the housing 67 and the front panel 66.

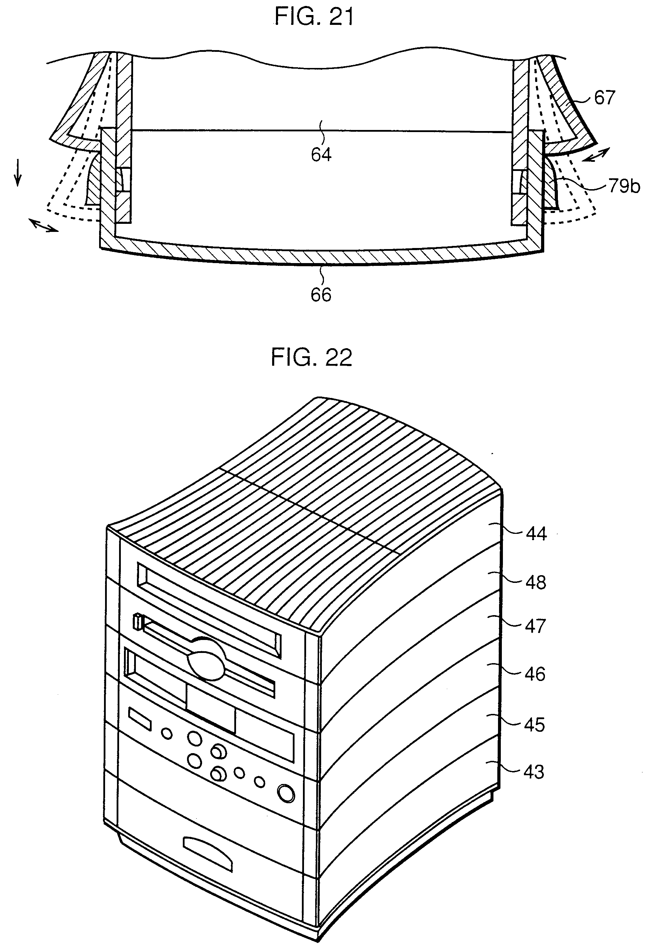

To couple two units together, their positioning guides 74 are aligned together after causing a rearward sliding of the housing 67 of one of them, and the female connector 73 on the top of one of them is coupled to the male connector 72 of the other. At this time, the six lock pawls 75a at the bottom of the other, i.e., lower, unit are inserted in the six lock notches 75b at the top of the upper unit. Then, as shown in Fig. 21, the housing 67 that has been held at the rearward slid position is caused to slide forward, (i.e., toward the front panel 66) and is thus secured to the snap fit portions 79b of the front panel 66. At this time, the lock pawls 75a are deviated from the lock notches 75b, whereby the housing 67 and the front panel 66 are secured to each other and also the two units are secured to each other. In this way, a new unit can be additionally provided.

For inserting a new unit C between two units (the upper unit being referred to as unit A, the lower unit being referred to as unit B), first the two units A and B are separated from each other. The two units can be separated by releasing the lock in the converse operation to the case of coupling the units. The housing 67 of only the unit C to be inserted is held at a rearward slid position, while in the other units A and B the front panel 66, housing 67 and unit frame 64 are held secured to one another. The connector 65 of the unit C to be inserted is secured to the connector 65 of the lower unit B by coupling together the front panel positioning guides 74a and 74b. Then, the connector 65 of the upper unit A is connected likewise to the top of the unit C in that state. Then, the housing 67 of the unit C is caused to slide forward, thus effecting the coupling of the housing 67 and front panel 66 of the unit C while at the same time securing together the housings 67 of the units A to C at a time.

As shown above, any unit can be additionally provided when desired, and it is not necessary to preliminarily provide the personal computer body with an expansion space for additionally providing circuit boards and circuit components and selectively removing those for version-up. Also, units which have become unnecessary and are to be discarded and also units to be replaced for version-up can be easily removed in the converse operation to the additional provision of units.

Furthermore, since each unit is serially connected via the common system bus 49, it is possible by merely changing the counterpart unit of connection to interchange the sequence of connection of units as shown in the block diagram of Fig. 16 showing Embodiment 3 or additionally provide or replace a unit between non-terminal units as shown in the block diagram of Fig. 17 also showing Embodiment 3.

While the invention has been described in its preferred embodiments, it is to be understood that the words which have been used are words of description rather than limitation and that changes within the purview of the appended claims may be made without departing from the true scope of the invention as defined by the claims.

Each feature disclosed in the specification (which term includes the claims) and/or shown in the drawings may be incorporated in the invention independently of other disclosed and/or illustrated features.

The text of the abstract filed herewith is hereby deemed to be repeated here in full as part of the specification.

Each feature disclosed in the description, and (where appropriate) the claims and drawings may be provided independently or in any appropriate combination.

## Claims

1. Modular electronic apparatus comprising:
at least two units (11,12) having electronic components (63); and
an integral housing (21,22) accommodating said units (11,12);
characterised in that;
said integral housing comprises at least two independent housings (21,22) accommodating a respective unit and being connectable to form said integral housing.

2. An electronic module (11), for use in apparatus such as Claim 1 and for interacting with another electronic module (12), each electronic module (11,12) comprising electronic components (63) and contained in an independent housing (21,22);
characterised by said independent housings (21,22) being connectable to form an integral housing (21,22) containing both modules.

3. A small-size electronic apparatus characterized by comprising:
a plurality of units (11,12,13,14;27,28,29;43,44,45) each having a circuit board (63,71) and an independent housing (21,22,23;37,38,39; 53,54;66,67) accommodating therein various functional components on a function to function basis; and
at least one connecting means (24,40,55,65) provided in each of said plurality of units, said connecting means being connected to desired one of said plurality of units.

4. The small-size electronic apparatus according to claim 3, in which said connecting means comprises a cable (25,41) having at each of two ends a connector (24,40), said cable interconnecting the desired ones of said units.

5. The small-size electronic apparatus according to claim 3 or 4 in which said connecting means comprises a pair of male and female connectors (56,57;72,73), said male and female connectors being provided on opposed walls of said housing of the unit, said desired ones of the plurality of units being directly interconnected by said connectors such that said units are stacked one on top of another.

6. A small-size electronic apparatus having a combination of a plurality of units (44) each comprising a circuit board (63) and various functional components housed independently in said units on a function to function basis, each of said units characterized by further comprising:
a unit frame (64) in which said circuit board and said functional components are mounted, and which has a connector (65) for electrically being connected to a circuit board and functional components of other units in a direction of connection to said other units;
a front panel (66) which has a first and a second fit coupling means (79a,79b), said front panel being connected to and removed from said unit frame by said first fit coupling means; and
a housing (67) which receives said unit frame (64), and which has a guide rail means (78) for interconnecting said housing with said unit frame (64) and a unit connection surface having a locking means (75a,75b) for interconnecting and locking said units together, such that, by causing said housing to slide along said guide rail means toward said front panel, said housing is secured to said unit frame and said front panel by said second fit coupling means, and also housings of said plurality of units are interconnected and locked.

7. The small-size electronic apparatus according to claim 3, 4 or 5, in which said connectors have dimensions and shapes in common.

8. The small-size electronic apparatus according to claims 3, 4, 5 or 7, in which said plurality of units include a connector unit (14) through which individual units are capable of being bi-directionally accessed by one another.
